(19)

Europäisches
Patentamt
European
Patent Office
Office européen
des brevets

(11) **EP 1 784 054 A1**

(12) **EUROPEAN PATENT APPLICATION**
published in accordance with Art. 158(3) EPC

(43) Date of publication:
**09.05.2007 Bulletin 2007/19**

(21) Application number: **05768330.2**

(22) Date of filing: **02.08.2005**

(51) Int Cl.:
**H05B 33/04** *(2006.01)*   **H05B 33/12** *(2006.01)*
**H05B 33/14** *(2006.01)*

(86) International application number:
**PCT/JP2005/014127**

(87) International publication number:
**WO 2006/022123 (02.03.2006 Gazette 2006/09)**

(84) Designated Contracting States:
**DE FR GB**

(30) Priority: **26.08.2004 JP 2004246449**

(71) Applicant: **IDEMITSU KOSAN CO., LTD.**
**Tokyo 100-8321 (JP)**

(72) Inventors:
• **EIDA, Mitsuru**
**2990293 (JP)**

• **FUKUDA, Masahiko**
**2990293 (JP)**

(74) Representative: **Gille Hrabal Struck Neidlein Prop Roos**
**Brucknerstrasse 20**
**40593 Düsseldorf (DE)**

(54) **ORGANIC EL DISPLAY DEVICE**

(57)   An organic EL display comprising: an organic EL substrate (100) wherein organic EL devices (40) are formed on a first substrate (10), a color conversion substrate (200) wherein color conversion layers (70) are formed on a second substrate (60), the organic EL substrate (100) and the color conversion substrate (200) being arranged in such a way that the organic EL devices (40) face the color conversion layers (70), transparent walls (80) which are thicker than the color conversion layers (70) and are provided between the color conversion layers (70) of the color conversion substrate (200), the transparent walls (80) being partition walls for separating the color conversion layers (70) and being spacers between the organic EL substrate (100) and the color conversion substrate (200), and a sealing medium (90), the sealing medium (90) and the color conversion layers (70) being provided between the transparent walls (80).

FIG.1

EP 1 784 054 A1

**Description**

TECHNICAL FIELD

The invention relates to an organic electroluminescent (EL) display, and particularly to an organic EL display including a color conversion layer.

BACKGROUND ART

In recent years, various flat displays such as a liquid crystal display (LCD) have been developed. In particular, an EL display exhibits excellent visibility due to self luminescence and is completely solid to exhibit excellent impact resistance. In the EL display, a voltage is applied between two electrodes provided on either side of an emitting layer including an organic compound, an inorganic compound, or the like to cause current to flow through the emitting layer, whereby the emitting layer emits light.

As a method of realizing a full-color EL display, a method has been known in which a fluorescent layer is allowed to absorb EL light from an emitting layer and to emit fluorescence (color changing medium (CCM) system). This allows blue EL light to be converted into green or red fluorescence, for example.

This EL display includes a color conversion member (color conversion substrate) in which light blocking layers and different color conversion layers including one or more fluorescent material layers are alternately and separately disposed on a transparent supporting substrate, and luminescent members (EL substrate) which are separately disposed at positions corresponding to the color conversion layers, the color conversion member and the luminescent members being disposed so that the color conversion layer receives light from each luminescent member and emits light of a different color.

The fluorescent material layer (color conversion layer) must absorb sufficient EL light and emit fluorescence with high efficiency. This requires that the thickness of the fluorescent material layer be about ten times or more of the thickness of a color filter (1 to 2 $\mu$m) used for a liquid crystal or the like. The reason therefor is as follows. Specifically, in order to allow the fluorescent material layer to absorb sufficient EL light, it is necessary to increase the concentration of the fluorescent material. In this case, since quenching (concentration quenching) of fluorescence occurs due to association of the fluorescent material, it is necessary to increase the thickness of the fluorescent material layer to increase the absorption efficiency without decreasing the fluorescence efficiency.

On the other hand, it is necessary to separately dispose (pattern) the fluorescent material layers with a high resolution in order to realize a full-color EL display.

A large-size and high-resolution full-color organic EL display has been studied in which an organic EL substrate and a color conversion substrate are oppositely formed. Known configurations of such an organic EL display are given below.

(1) In patent document 1, a partition wall of a color conversion layer formed on a color conversion substrate is formed of a light blocking layer. Since only a light blocking layer with a rough pattern (aspect ratio (thickness/width) = 1/2 or less) can be formed due to the low patterning accuracy, it is difficult to obtain a high-resolution color conversion substrate and a high-resolution organic EL display.

(2) In patent document 2, a partition wall is disposed on the periphery of a display region of a display. In this case, the center of the display is warped when forming a large organic EL display, whereby the organic EL display may exhibit insufficient impact resistance, or the luminous uniformity on the screen may be decreased.

(3) In patent documents 3 and 4, a color conversion substrate and an organic EL substrate are oppositely provided through a support (spacer) or a stress reducing layer. A light blocking layer (black matrix) is provided between color conversion layers, and a support is separately disposed on the light blocking layer. According to this configuration, a problem similar to that of (1) occurs. Moreover, since the thick light blocking layer and the support or the stress reducing layer are separately required, the configuration becomes complicated, whereby cost is increased.

(4) In patent document 5, a cylindrical body is formed on a color conversion substrate. In this case, an overcoat layer for filling the gap between color conversion layers is required. Moreover, since pressure is applied to an organic luminescent medium when the cylindrical body is provided in the organic EL emitting region, the organic luminescent medium may be destroyed due to stress caused by a change in temperature or the like, whereby display defects may occur.

(5) In patent document 6, a color conversion substrate is formed in which color conversion layers are separated by a transparent partition wall. In patent document 6, an organic EL device is directly stacked on the color conversion substrate. That is, the color conversion substrate and the organic EL substrate are not oppositely provided. The partition wall does not function as a spacer between the color conversion substrate and the organic EL substrate. Moreover, since the organic EL device is directly affected by the surface flatness of the color conversion substrate and volatile components such as water, display defects such as breakage, short circuit, and dark spots tend to occur.

[Patent document 1] WO98/34437
[Patent document 2] JP-A-2004-103534
[Patent document 3] JP-A-2003-243154
[Patent document 4] JP-A-2003-282259
[Patent document 5] JP-A-2003-257658
[Patent document 6] JP-A-2003-229260

An object of the invention is to provide a large-size and high-resolution organic EL display which has a simple configuration, shows display defects to only a small extent, and exhibits impact resistance.

DISCLOSURE OF THE INVENTION

An organic EL display provided according to the invention and its effects are as follows.

1. An organic EL display comprising:

an organic EL substrate wherein organic EL devices are formed on a first substrate,
a color conversion substrate wherein color conversion layers are formed on a second substrate, the organic EL substrate and the color conversion substrate being arranged in such a way that the organic EL devices face the color conversion layers,
the transparent walls being partition walls for separating the color conversion layers and being spacers between the organic EL substrate and the color conversion substrate, and
a sealing medium, the sealing medium and the color conversion layer being provided between the transparent walls.

The term "transparent" of the transparent partition wall means that the partition wall has a transmittance of light in the visible region at a wavelength of 400 nm to 700 nm of more than 10%. The partition wall preferably has a transmittance of light with a wavelength of 400 to 450 nm of more than 10%. This ensures a light transmittance in the ultraviolet region of less than 400 nm, whereby a photosensitive resin used as the wall material can be sufficiently exposed during exposure step of photolithography process. Therefore, a partition wall with a large thickness and a high resolution can be easily obtained.

The wall preferably has an aspect ratio (height/width) of 1/2 (0.5) to 10/1 (10) and a thickness of 1 $\mu$m to 50 $\mu$m. The aspect ratio is more preferably 2/3 (0.67) to 5/1 (5), and the thickness is more preferably 5 $\mu$m to 30 $\mu$m.

In the light blocking layer disclosed in the patent document 1 and the like which corresponds to the wall according to the invention, a light blocking material is contained in a photosensitive resin. Since the light blocking material usually absorbs light in the photosensitive region of the photosensitive resin (usually 300 to 450 nm), the photosensitive resin cannot be sufficiently exposed during exposure step of photolithography process, whereby it is difficult to increase the thickness and resolution of the light blocking layer. When forming the light blocking layer using a metal material with a large thickness, it is difficult to accurately etch the metal layer with a large thickness.

The invention achieves an increase in thickness and resolution by forming the wall using a transparent material. Since a high-resolution partition wall can be obtained by disposing the transparent partition wall between the color conversion layers, the resolution of the color conversion layer can also be increased. Moreover, the aperture ratio of the organic EL display can be increased, whereby luminous efficiency is improved.

Since the thickness of the partition wall can be increased, when using a fluorescent layer as the color conversion layer, the thickness of the fluorescent layer can also be increased. Therefore, the fluorescence conversion efficiency of the fluorescent material is improved so that the luminous efficiency of the organic EL display is improved.

Since the transparent wall also serves as the spacer between the organic EL substrate and the color conversion substrate, the organic EL substrate and the color conversion substrate can be oppositely bonded stably (while controlling the gap) through the spacer, whereby the impact (mechanical and thermal) stability of a large-size organic EL display can be improved. Moreover, since the organic EL device is not directly affected by the surface flatness of the color conversion substrate and volatile components such as water, defects of the organic EL display can be reduced.

Since the transparent partition wall separates the color conversion layers and also serves as the spacer, the configuration of the organic EL display is simplified, whereby an inexpensive organic EL display can be obtained.

2. The organic EL display according to 1, wherein a light blocking layer is formed at the upper and/or under parts of the transparent walls.

The contrast of the organic EL display is improved by forming the light blocking layer, whereby viewing-angle dependence when forming a multicolor or full-color display can be reduced. Note that the light blocking layer is formed of a thin film so that an increase in resolution and aperture ratio is not hindered, and does not have a function of separating the color conversion layers.

    3. The organic EL display according to 1 or 2, wherein a refractive index of the transparent walls is different from a refractive index of the color conversion layers.

This configuration suppresses a problem in which light from the color conversion layer of one sub-pixel is mixed into the adjacent sub-pixel, whereby the color reproducibility of the organic EL display is improved.

    4. The organic EL display according to any one of 1 to 3, wherein a side of the transparent walls has a function of reflecting visible light.

Light from the color conversion layer is reflected by the side of the wall and effectively utilized for display of the organic EL display.

In more detail, a reflecting layer is disposed on the side of the wall, or the partition wall is formed to scatter and reflect visible light.

    5. The organic EL display according to any one of 1 to 4, wherein a width of the transparent walls becomes smaller gradually or stepwise from the first substrate (substrate on which the organic EL device is formed) toward the second substrate (substrate on which the color conversion layer is formed).

This increases the area of the color conversion layer on the light-outcoupling side, whereby luminous efficiency is further improved. Moreover, when providing the color conversion layer between the partition walls using an inkjet method, screen printing, or the like, the surface of each color conversion layer is further planarized, whereby a variation in the color of emitted light in the sub-pixel or between the sub-pixels is reduced. The statement "becomes smaller gradually or stepwise" means that the transparent wall has a reverse-trapezoidal cross-sectional shape or a cross-sectional shape in the shape of the letter T, for example.

    6. The organic EL display according to any one of 1 to 5, wherein the color conversion layers comprise semiconductor particles.

This provides a color conversion layer which exhibits improved conversion efficiency and chromaticity and excellent durability.

Moreover, since the average refractive index of the color conversion layer is increased so that the difference in refractive index between the color conversion layer and the transparent partition wall is increased, light from the color conversion layer is mixed into the adjacent color conversion layer to only a small extent. As a result, the color reproducibility of light from the organic EL display is improved.

    7. The organic EL display according to any one of 1 to 6, wherein the color conversion layers comprise a fluorescent layer and/or a color filter.

The chromatic purity of light from the organic EL display can be improved by combining the fluorescent layer and the color filter, and contrast can be improved by blocking external excitation light entering the fluorescent material layer using the color filter. A full-color organic EL display may be formed by combining a white organic EL device and a fluorescent layer and/or a color filter.

    8. The organic EL display according to any one of 1 to 7, wherein the organic EL devices are active-driven.

This allows provision of a large-size and high-resolution organic EL display in which the organic EL device is driven at a low voltage and is not subjected to load.

According to the invention, a large-size and high-resolution organic EL display can be provided which has a simple configuration and exhibits impact resistance. This organic EL display can be manufactured at low cost due to the simple configuration.

BRIEF DESCRIPTION OF THE DRAWING

FIG. 1 is a view showing an organic EL display according to one embodiment of the invention.
FIG. 2 is a view showing an organic EL display according to another embodiment of the invention.
FIG. 3 is a view showing an organic EL display according to another embodiment of the invention.
FIG. 4 is a view showing an organic EL display according to yet another embodiment of the invention.
FIG. 5 (a) is a schematic top view showing the end of a stripe pattern of partition walls, and FIG. 5(b) is a schematic top view showing an example in which a perpendicular partition wall is formed.
FIG. 6 (a) is a schematic view showing an example in which a transparent partition wall has a rectangular cross-sectional shape, and FIG. 6(b) is a schematic view showing an example in which a transparent partition wall has a reverse trapezoidal cross-sectional shape.
FIG. 7 is a view showing polysilicon TFT formation steps.
FIG. 8 is a circuit diagram showing an electric switch connection structure including a polysilicon TFT.
FIG. 9 is a planar perspective view showing an electric switch connection structure including a polysilicon TFT.

BEST MODE FOR CARRYING OUT THE INVENTION

First embodiment

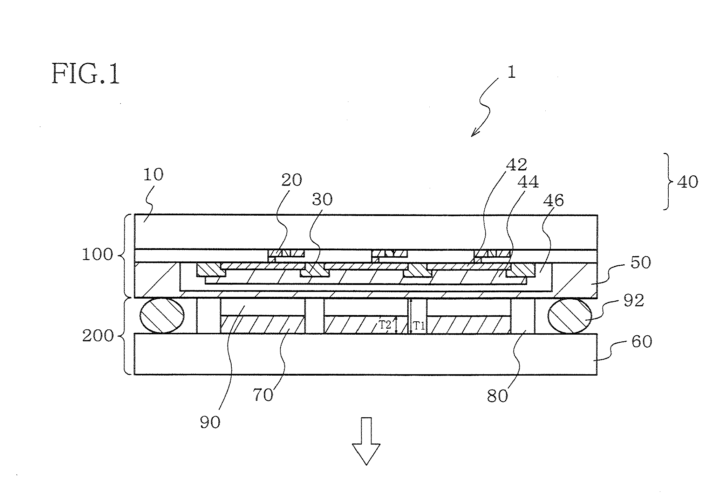

FIG. 1 shows an organic EL display according to one embodiment of the invention.

In an organic EL display 1, an organic EL substrate 100, in which an organic EL device 40 is formed on a first substrate 10, and a color conversion substrate 200, in which a color conversion layer 70 is formed on a second substrate 60, are disposed so that the organic EL device 40 faces the color conversion layer 70.

In the organic EL substrate 100, a TFT 20, an inter-insulator 30, a lower electrode 42, an organic luminescent medium 44, an upper electrode 46, and a barrier film 50 are formed on the first substrate 10. The lower electrode 42, the organic luminescent medium 44, and the upper electrode 46 make up the organic EL device 40.

In the color conversion substrate 200, the color conversion layer 70 and a transparent partition wall 80 are formed on the second substrate 60. The partition wall 80 is provided between the color conversion layers 70 and separates the color conversion layers 70. The partition wall 80 has a thickness T1 greater than the thickness T2 of the color conversion layer 70, and functions as a spacer between the organic EL substrate 100 and the color conversion substrate 200. A sealing medium 90 is provided between the partition walls 80 in addition to the color conversion layer 70.

The organic EL substrate 100 and the color conversion substrate 200 are bonded and sealed using a sealing adhesive layer 92 with the sealing medium 90 interposed therebetween.

In this embodiment, since a transparent material is used for the wall 80 when forming the wall 80 on the second substrate by photolithography process, the thickness and the resolution of the wall 80 can be increased.

This ensures that the resolution of the color conversion layer 70 and the aperture ratio of the organic EL display can be increased, whereby luminous efficiency is improved.

Moreover, since the thickness of the partition wall 80 can be increased, when using a fluorescent layer as the color conversion layer 70, the thickness of the fluorescent layer can be increased, whereby the fluorescence conversion efficiency of the fluorescent material is improved. Therefore, the luminous efficiency of the organic EL display is improved.

Since the transparent wall 80 also serves as the spacer, the organic EL substrate 100 and the color conversion substrate 200 can be stably disposed through the spacer, whereby the impact (mechanical and thermal) stability of a large-size organic EL display can be improved.

Since the partition wall 80 separates the color conversion layers 70 and also serves as the spacer, the configuration of the organic EL display is simplified, whereby an inexpensive organic EL display can be obtained.

Light from the organic EL device 40 is converted into light with a different wavelength or light of a different color by the color conversion layer 70, and outcoupled in the direction indicated by the arrow. A monochrome (e.g. white) display is obtained when using the identical color conversion layers 70, and a full-color display is obtained when using different color conversion layers 70 so that the three primary colors are obtained.

The partition wall 80 preferably has a refractive index differing from the refractive index of the color conversion layer 70.

When using a plurality of types of color conversion layers which differ in refractive index, the partition wall 80 preferably has a refractive index differing from the refractive indices of all the color conversion layers.

This suppresses a problem in which light from the color conversion layer of one sub-pixel is mixed into the adjacent sub-pixel, whereby the color reproducibility of the organic EL display is improved.

Note that the organic EL display according to this embodiment is a top-emission type which allows an increase in aperture ratio.

Second embodiment

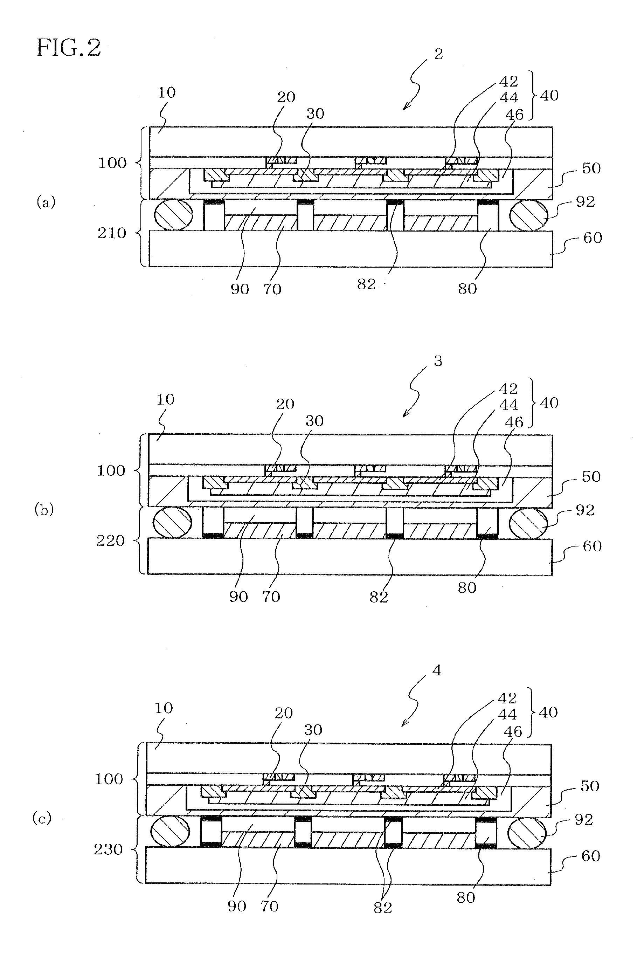

FIG. 2 shows an organic EL display according to another embodiment of the invention.

In the drawings, the same members as the members shown in FIG. 1 are indicated by the same symbols. Description of these members is omitted.

This embodiment differs from the first embodiment as to the partition wall of the color conversion substrate.

In an organic EL display 2 in FIG. 2 (a), a light blocking layer 82 is formed at the top of the partition wall 80 of a color conversion substrate 210.

In an organic EL display 3 in FIG. 2(b), the light blocking layer 82 is formed at the bottom of the partition wall 80 of a color conversion substrate 220.

In an organic EL display 4 in FIG. 2(c), the light blocking layers 82 are formed at the top and bottom of the partition wall 80 of a color conversion substrate 230.

The contrast of the organic EL display is improved by forming the light blocking layer 82, whereby viewing-angle dependence when forming a multicolor or full-color display can be reduced. Note that the light blocking layer is formed of a thin film so that an increase in resolution and aperture ratio is not hindered, and does not have a function of separating the color conversion layers.

Third embodiment

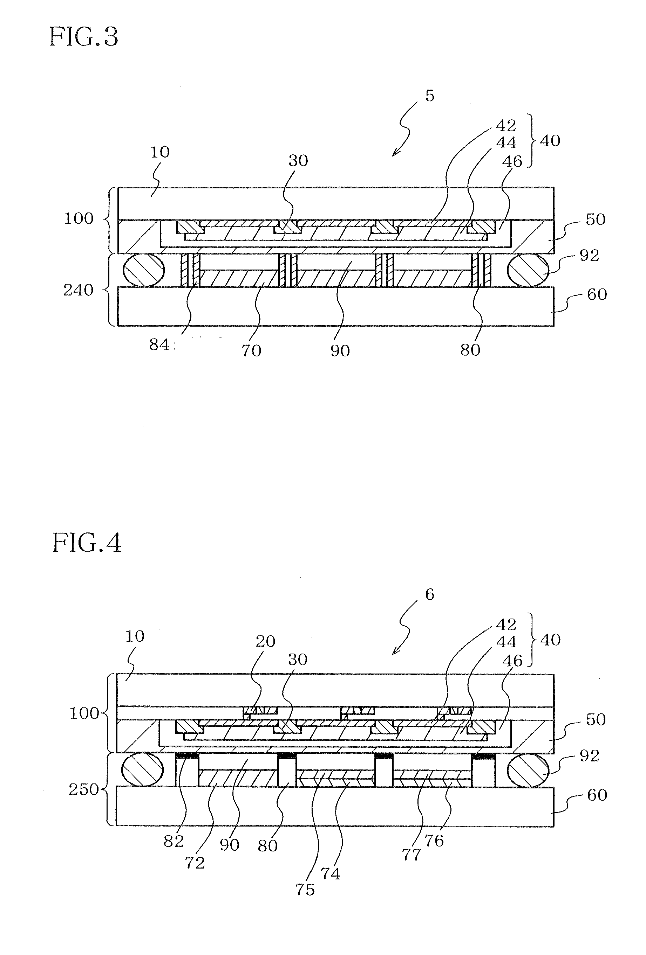

FIG. 3 shows an organic EL display according to another embodiment of the invention.

This embodiment differs from the first embodiment as to the partition wall of the color conversion substrate.

In an organic EL display 5 in FIG. 3, a reflecting layer 84 having a function of reflecting visible light is formed on the side of the partition wall 80 of a color conversion substrate 240.

Light from the color conversion layer 70 is reflected by the reflecting layer 84 and effectively utilized for display of the organic EL display. Note that the side of the partition wall may be roughened so that the side of the partition wall reflects visible light, or particles with a refractive index differing from the refractive index of the partition wall may be dispersed in the partition wall to such an extent that the transparency of the partition wall is not impaired to scatter and reflect visible light.

Fourth embodiment

FIG. 4 shows an organic EL display according to yet another embodiment of the invention.

This embodiment differs from the second embodiment (a) as to the configuration of the color conversion layer.

In an organic EL display 6 in FIG. 4, when the organic EL device 40 emits blue light, the color conversion layers 70 include a blue sub-pixel (blue conversion layer), a green sub-pixel (green conversion layer), and a red sub-pixel (red conversion layer) in order to realize a full-color display.

The blue sub-pixel (blue conversion layer) includes a blue filter 72, the green sub-pixel (green conversion layer) includes a green filter 74 and a green fluorescent layer 75, and the red sub-pixel (red conversion layer) includes a red filter 76 and a red fluorescent layer 77. The green fluorescent layer 75 converts blue light into green light, and the red fluorescent layer 77 converts blue light into red light.

The chromatic purity of light from the organic EL display can be improved by combining the fluorescent layer and the color filter, and contrast can be improved by blocking external excitation light entering the fluorescent layer using the color filter.

Each member according to the above embodiments is described below.

1. Color conversion substrate

The color conversion substrate includes the transparent substrate, the transparent partition wall, and the color conversion layer, and optionally includes the light blocking layer and the reflecting layer.

(1) Transparent substrate (corresponding to second substrate 60)

The transparent substrate used in the invention is a substrate which supports the organic EL display. The transparent substrate is preferably a flat and smooth substrate with a transmittance of light in the visible region at a wavelength of 400 nm to 700 nm of 50% or more. As specific examples of the transparent substrate, a glass plate, a polymer plate, and the like can be given. As examples of the material for the glass plate, soda lime glass, barium-strontium-containing glass, lead glass, aluminosilicate glass, borosilicate glass, barium borosilicate glass, quartz, and the like can be given. As examples of the material for the polymer plate, polycarbonate, acryl, polyethylene terephthalate, polyether sulfide, polysulfone, and the like can be given.

(2) Transparent partition wall

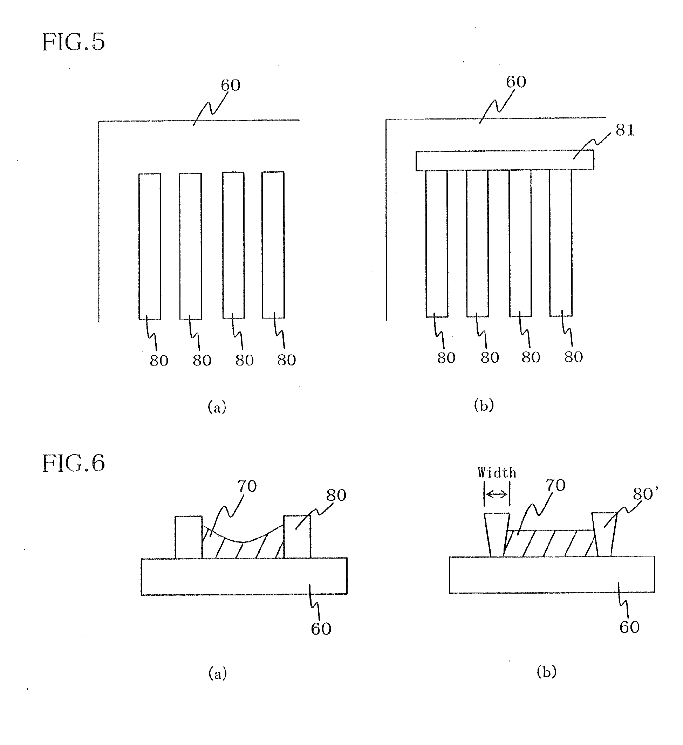

The transparent partition wall used in the invention is disposed between the color conversion layers of the color conversion substrate to separate the color conversion layers, and also serves as the spacer between the organic EL substrate and the color conversion substrate. The term "transparent" of the transparent partition wall means that the partition wall has a transmittance of light in the visible region at a wavelength of 400 nm to 700 nm of more than 10%. The partition wall preferably has a transmittance of light with a wavelength of 400 to 450 nm of more than 10%. This ensures that the partition wall also transmits light in the ultraviolet region of less than 400 nm, whereby a photosensitive resin used as the partition wall material can be sufficiently exposed during exposure step of photolithography process. Therefore, a partition wall with a large thickness and a high resolution is easily obtained.
The aspect ratio (height/width) of the partition wall is preferably 1/2 (0.5) to 10/1 (10), and more preferably 2/3 (0.67) to 5/1 (5). If the aspect ratio is less than 1/2 (0.5), an increase in resolution and aperture ratio may not be achieved. If the aspect ratio exceeds 10/1 (10), the stability of the partition wall may deteriorate.
The width of the partition wall is preferably 1 $\mu$m to 50 $\mu$m, and more preferably 5 $\mu$m to 30 $\mu$m. If the width is less than 1 $\mu$m, the stability of the partition wall as the spacer may deteriorate. If the width exceeds 50 $\mu$m, an increase in resolution and aperture ratio may not be achieved.
A preferred thickness is calculated from the above-mentioned preferred aspect ratio and width. This thickness is in the range of 0.5 $\mu$m to 500 $\mu$m.
The transparent partition wall may have a grid-like or a stripe-like surface shape. The grid-like surface shape is preferable when it is desired to arbitrarily change the color arrangement. On the other hand, the stripe-like surface shape is preferable when it is desired to ensure the uniformity and stability of the color conversion layer. When providing the color conversion layer between the partition walls using an inkjet method, screen printing, or the like, it is preferable to form a partition wall on the end of the stripe pattern of the partition walls perpendicularly to the stripe in order to suppress the flow of the color conversion layer. FIG. 5 shows an example.
FIG. 5 (a) is a schematic top view showing the end of the stripe pattern of the partition walls, and FIG. 5(b) is a schematic top view showing an example in which a perpendicular partition wall is formed. Note that only the second substrate and the transparent partition walls are illustrated for convenience, and other members are omitted. A perpendicular partition wall 81 is formed on the end of the stripe pattern of the partition walls 80 formed on the second substrate 60.
It is preferable that the width of the transparent partition wall become smaller gradually or stepwise from the first substrate (substrate on which the organic EL device is formed) toward the second substrate (substrate on which the color conversion layer is formed). Specifically, it is preferable that the cross-sectional shape of the transparent partition wall, which is usually rectangular, be reverse trapezoidal or in the shape of the letter T.
FIG. 6 (a) is a schematic view showing an example in which the transparent partition wall has a rectangular cross-sectional shape, and FIG. 6 (b) is a schematic view showing an example in which the transparent partition wall has a reverse trapezoidal cross-sectional shape. Note that only the second substrate, the transparent partition walls, and the color conversion layer are illustrated for convenience, and other members are omitted. In FIG. 6(b), a reverse trapezoidal transparent partition wall 80' is formed on the second substrate 60. The color conversion layer 70 is formed between the transparent partition walls 80'. This configuration increases the area of the color conversion layer 70 on the light-outcoupling side, whereby luminous efficiency is further improved. Moreover, when providing the color conversion layer 70 between the partition walls 80' using an inkjet method, screen printing, or the like, the surface of each color conversion layer 70 is further planarized, whereby a variation in the color of emitted light in the sub-pixel or between the sub-pixels is reduced.
As the material for the transparent partition wall, a photosensitive resin to which photolithography process can be applied is selected. Examples of such a photosensitive resin include a photocurable resist material having a reactive vinyl group, such as an acrylic material, a methacrylic material, a polyvinyl cinnamate material, and a cyclized rubber material. These resist materials may be liquid or a film (dry film).
The transparent partition wall may include particles such as various dyes and pigments insofar as the transparency of the partition wall is not impaired.

It is preferable that the transparent partition wall have a refractive index differing from the refractive index of the color conversion layer. If the transparent partition wall has a refractive index differing from the refractive index of the color conversion layer, a problem can be suppressed in which light from the color conversion layer is reflected at the interface between the color conversion layer and the partition wall and mixed into the adjacent sub-pixel, whereby the color reproducibility of the organic EL display is improved. The difference in refractive index between the color conversion layer and the transparent partition wall is preferably 0.1 or more.

It is preferable that the side of the transparent partition wall have a function of reflecting visible light. Specific examples are described later.

(3) Color conversion layer

The color conversion layer includes the fluorescent layer and/or the color filter.

(3)-1. Fluorescent layer

The fluorescent layer has a function of converting light from a luminescent material such as an EL device into light containing a component with a longer wavelength. For example, a blue light component (wavelength of 400 nm to 500 nm) of light from the luminescent material is absorbed by the color conversion layer and converted into green or red light with a longer wavelength. Note that the color conversion layer according to the invention may transmit part of the blue light component from the luminescent material and mix yellow-red converted light to convert light from the luminescent material into white light.

The fluorescent layer includes at least a fluorescent material which converts the wavelength of light from the luminescent material and may be dispersed in a binder resin, as required.

As the fluorescent material, an organic fluorescent material such as a fluorescent dye and an inorganic fluorescent material may be used.

As examples of the organic fluorescent material which converts near ultraviolet light to violet light from the luminescent material into blue light, stilbene dyes such as 1,4-bis(2-methylstyryl)benzene (Bis-MBS) and trans-4,4'-diphenylstilbene (DPS), and coumarin dyes such as 7-hydroxy-4-methylcoumarin (coumarin 4) can be given.

As examples of the fluorescent material which converts blue, blue green, or white light into green light, coumarin dyes such as 2,3,5,6-1H,4H-tetrahydro-8-trifluoromethylquinolizino(9,9a, 1-gh)coumarin (coumarin 153), 3-(2'-benzothiazolyl)-7-diethylaminocoumarin (coumarin 6), and 3-(2'-benzimidazolyl)-7-N,N-diethylaminocoumarin (coumarin 7), basic yellow 51 which is another coumarin dye, naphthalimido dyes such as solvent yellow 11 and solvent yellow 11.6, and perylene dyes can be given.

As examples of the fluorescent material which converts blue to green light or white light into orange to red light, cyanine dyes such as 4-dicyanomethylene-2-methyl-6-(p-dimethylaminostyryl)-4H-pyrane (DCM), pyridine dyes such as 1-ethyl-2-(4-(p-dimethylaminophenyl)-1,3-butadienyl)-pyridinium-perchlorate (pyridine 1), rhodamine dyes such as rhodamine B, rhodamine 6G, and basic violet 11, oxazine dyes, and the like can be given.

Various dyes (e.g. direct dye, acid dye, basic dye, and disperse dye) may be selected as the fluorescent material insofar as the dye exhibits fluorescent properties.

A pigment may also be used which is prepared by mixing the fluorescent material into a pigment resin such as polymethacrylate, polyvinyl chloride, a vinyl chloride-vinyl acetate copolymer, an alkyd resin, an aromatic sulfonamide resin, a urea resin, a melanine resin, or a benzoguanamine resin.

As the inorganic fluorescent material, an inorganic fluorescent material formed of an inorganic compound such as a metal compound may be used which absorbs visible light and emits fluorescence with a wavelength longer than that of the absorbed light. The surface of the fluorescent material may be modified with an organic substance such as a long-chain alkyl group or phosphoric acid in order to improve dispersibility in a binder resin described later, for example. The durability of the fluorescent layer can be further improved by using the inorganic fluorescent material. In more detail, the following inorganic fluorescent materials may be used.

(a) Particle obtained by doping metal oxide with transition metal ion

A particle obtained by doping a metal oxide such as $Y_2O_3$, $Gd_2O_3$, ZnO, $Y_3Al_5O_{12}$, or $Zn_2SiO_4$ with a transition metal ion which absorbs visible light, such as $Eu^{2+}$, $Eu^{3+}$, $Ce^{3+}$, or $Tb^{3+}$.

(b) Particle obtained by doping metal chalcogenide with transition metal ion

A particle obtained by doping a metal chalcogenide such as ZnS, CdS, or CdSe with a transition metal ion which absorbs visible light, such as $Eu^{2+}$, $Eu^{3+}$, $Ce^{3+}$, or $Tb^{3+}$. The surface of the particle may be modified with a metal oxide such as silica, an organic substance, or the like in order to prevent removal of S, Se, or the like due to reaction components of the binder resin described later.

(c) Particle which absorbs visible light and emits light utilizing band gap of semiconductor

A semiconductor particle such as CdS, CdSe, CdTe, ZnS, ZnSe, or InP. As known from the literature such as JP-T-2002-510866, the band gap of these semiconductor particles can be controlled by reducing the particle diameter to nanometers, whereby the absorption-fluorescence wavelength can be changed. The surface of the particle may be modified with a metal oxide such as silica, an organic substance, or the like in order to prevent removal of S, Se, or the like due to reaction components of the binder resin described later.

For example, the surface of a CdSe particle may be covered with a shell formed of a semiconductor material (e.g. ZnS) with a higher bandgap energy. This ensures that confinement effects for electrons produced in the core particle are easily obtained.

The particle diameter and/or the composition of the semiconductor particle is changed corresponding to the color of light emitted from the color conversion layer. For example, when changing the color of light using a semiconductor particle of the same composition, the diameter of the semiconductor particle is changed. On the other hand, when changing the color of light using a semiconductor particle of a different composition, a semiconductor particle with approximately the same particle diameter may be used.

When changing the color of emitted light by changing the particle diameter, it may be difficult to control the particle diameter depending on the composition. Therefore, it is preferable to change the color of light using a semiconductor particle of a different composition.

It is preferable that the particle diameter distribution be as small as possible, since luminescence becomes sharp so that the chromatic purity of emitted light and luminous efficiency are improved. The particle diameter distribution is preferably 20% or less, more preferably 10% or less, and still more preferably 5% or less. The particle diameter distribution (%) is calculated using the following expression.

```
Particle diameter distribution (%) = (standard deviation of
particle diameter / average particle diameter) × 100
```

The above inorganic fluorescent materials may be used either individually or in combination of two or more.

As the binder resin, it is preferable to use a transparent material (having a transmittance of visible light of 50% or more). As examples of such a material, transparent resins (polymers) such as a polyalkyl methacrylate, polyacrylate, an alkyl methacrylate/methacrylic acid copolymer, polycarbonate, polyvinyl alcohol, polyvinylpyrrolidone, hydroxyethyl cellulose, and carboxymethyl cellulose can be given.

A photosensitive resin to which photolithography process can be applied is also selected in order to separately dispose the fluorescent layers. Examples of such a photosensitive resin include a photocurable resist material having a reactive vinyl group, such as an acrylic material, a methacrylic material, a polyvinyl cinnamate material, and a cyclized rubber material. When using a printing method, a printing ink (medium) using a transparent resin is selected. For example, a thermoplastic or thermosetting transparent resin such as a polyvinyl chloride resin, a melamine resin, a phenol resin, an alkyd resin, an epoxy resin, a polyurethane resin, a polyester resin, a maleic resin, and a polyamide resin, in the form of a monomer, an oligomer, or a polymer, polymethyl methacrylate, polyacrylate, polycarbonate, polyvinyl alcohol, polyvinylpyrrolidone, hydroxyethyl cellulose, or carboxymethyl cellulose may be used.

The formation method for the fluorescent layer is mainly divided into the following two methods.

When the fluorescent layer is mainly formed of the fluorescent material, it is preferable to form the fluorescent layer on a substrate such as a glass plate by vacuum deposition through a mask which produces a desired color conversion layer pattern.

When the fluorescent layer is formed of the fluorescent material and the binder resin, it is preferable to form the fluorescent layer by mixing, dispersing, or solubilizing the fluorescent material, the binder resin, and an appropriate solvent to obtain a liquid, forming a film of the liquid on the substrate or the like using a method such as spin coating, roll coating, or casting, and patterning the resulting film into a desired color conversion layer pattern by photolithography process, or forming the liquid into a desired pattern using a method such as an inkjet method or screen printing.

The thickness of the fluorescent layer is not particularly limited insofar as the fluorescent layer receives (absorbs) sufficient light from the luminescent material and the color conversion function is not hindered. Since the thickness of the fluorescent layer must be equal to or smaller than the thickness of the partition wall, the thickness of the fluorescent layer is preferably 0.4 $\mu$m to 499 $\mu$m, and more preferably 5 $\mu$m to 100 $\mu$m.

(3)-2. Color filter

The material for the color filter is not particularly limited. As examples of the material for the color filter, a material containing a dye, a pigment, and a resin and a material containing only a dye and a pigment can be given. As the material for the color filter formed of a dye, a pigment, and a resin, a solid material obtained by dissolving or dispersing a dye and a pigment in a binder resin can be given.
As preferable examples of the dye and the pigment used for the color filter, perylene, isoindoline, cyanine, azo, oxazine, phthalocyanine, quinacridone, anthraquinone, diketopyrrolo-pyrrole, and the like can be given.
It is preferable that the color conversion layer according to the invention be formed by stacking the fluorescent layer and the color filter. Note that the color conversion layer may be a layer formed by mixing the above-mentioned fluorescent material and color filter material. This provides the color conversion layer with a function of converting light from the luminescent material and a function of a color filter which improves chromatic purity, whereby the configuration is simplified.
The formation method and the thickness of the color filter are the same as for the fluorescent layer.

(4) Light blocking layer

In the invention, it is preferable that the light blocking layer be formed at the top (upper part) and/or bottom (lower part) of the transparent partition wall.
The contrast of the organic EL display can be improved by forming the light blocking layer, whereby viewing-angle dependence when forming a multicolor or full-color display can be reduced.
It is difficult to increase the thickness and resolution of the light blocking layer since a light blocking material contained in a photosensitive resin usually absorbs light in the photosensitive region of the photosensitive resin (usually 300 to 450 nm), whereby the photosensitive resin cannot be sufficiently exposed during exposure step of photolithography process. When forming the light blocking layer using a metal material with a large thickness, it is difficult to accurately etch the metal layer with a large thickness. Accordingly, since only a light blocking layer with a rough pattern (aspect ratio (thickness/width) = 1/2 or less) can be formed due to the low patterning accuracy, it is difficult to obtain a high-definition color conversion substrate and a high-definition organic EL display. Therefore, the thickness of the light blocking layer according to the invention is preferably 10 nm to 5 $\mu$m, and more preferably 100 nm to 2 $\mu$m. It is preferable to reduce the thickness of the light blocking layer while maintaining the light blocking properties.
The light blocking layer may have a grid-like or a stripe-like surface shape. A grid-like surface shape is preferable in order to further improve the contrast of the organic EL display.
It is preferable that the light blocking layer have a transmittance of light from the luminescent member or light from the color conversion layer (particularly the fluorescent layer) (i.e. light in the visible region at a wavelength of 400 nm to 700 nm) of 10% or less, and more preferably 1% or less.
As examples of the material for the light blocking layer, the following metals and black dyes can be given. As the type of metal, one or more metals selected from Ag, Al, Au, Cu, Fe, Ge, In, K, Mg, Ba, Na, Ni, Pb, Pt, Si, Sn, W, Zn, Cr, Ti, Mo, Ta, stainless steel, and the like can be given. An oxide, nitride, sulfide, nitrate, sulfate, or the like of the above-mentioned metals may also be used. In addition, the metal material may contain carbon.
A film of the above material is formed at the bottom of the transparent partition wall (on the transparent substrate) or the top of the transparent partition wall by sputtering, deposition, CVD, ion plating, electrodeposition, electroplating, chemical plating, or the like, and patterned by photolithography process or the like to form a light blocking layer pattern. As examples of the black dye, carbon black, titanium black, aniline black, and a black dye obtained by mixing the above-mentioned color filter dyes can be given. The black dye or the metal material is dissolved or dispersed in a binder resin similar to that used for the color conversion layer, and the resulting solid material is patterned in the same manner as the color conversion layer to form a light blocking layer pattern at the top or bottom of the transparent partition wall.

(5) Reflecting function (at least side of partition wall)

It is preferable that the side of the transparent partition wall have a function of reflecting visible light. Light from the color conversion layer is reflected by the side of the partition wall and effectively utilized for display of the organic EL display.
The side of the partition wall is provided with the reflecting function by disposing a visible light reflecting layer on the side of the partition wall, roughening the side of the partition wall, or dispersing particles with a refractive index differing from the refractive index of the partition wall in the partition wall to such an extent that the transparency of the partition wall is not impaired to scatter and reflect visible light.
The reflecting layer preferably has a transmittance of light in the visible region at a wavelength of 400 to 700 nm of 10% or more, and preferably 50% or more.

The reflecting layer may be formed by forming a photoresist film in the area other than the side of the transparent partition wall, forming a film of the metal material used for the light blocking layer and a high-refractive-index material such as titanium oxide, magnesium oxide, or magnesium sulfate by sputtering, deposition, CVD, ion plating, or the like, and removing the photoresist (lift-off method), for example. In this case, the thickness of the reflecting layer is preferably 0.01 to 1 $\mu$m, and more preferably 0.05 to 0.5 $\mu$m from the viewpoint of uniformity and adhesion.

2. Organic EL substrate

The organic EL substrate generally includes a substrate and an organic EL device. The organic EL device includes an organic luminescent medium and an upper electrode and a lower electrode provided on either side of the organic luminescent medium. The constituent elements of the organic EL substrate are described below in the order of (1) supporting substrate, (2) organic luminescent medium, (3) upper electrode, (4) lower electrode, (5) inter-insulator, and (6) barrier film.

(1) Supporting substrate (corresponding to first substrate 10)

The supporting substrate of the organic EL display is a member for supporting the organic EL device and the like. It is preferable that the supporting substrate exhibit excellent mechanical strength and dimensional stability.
As examples of the material for the supporting substrate, a glass plate, a metal plate, a ceramic plate, a plastic plate (e.g. polycarbonate resin, acrylic resin, vinyl chloride resin, polyethylene terephthalate resin, polyimide resin, polyester resin, epoxy resin, phenol resin, silicon resin, fluororesin, and polyethersulfone resin), and the like can be given. It is preferable that the supporting substrate formed of such a material be provided with moisture-proof treatment or hydrophobic treatment by forming an inorganic film or applying a fluororesin in order to prevent water from entering the organic EL display.
In particular, it is preferable to reduce the water content and the steam or oxygen gas transmission coefficient of the supporting substrate in order to prevent water or oxygen from entering the organic luminescent medium. In more detail, it is preferable to adjust the water content of the supporting substrate 1 to 0.0001 wt% or less, and adjust the steam or oxygen transmission coefficient to $1 \times 10^{-13}$ cc·cm/cm$^2$·sec.cmHg or less.
In the invention, since EL emission is outcoupled from the side opposite to the supporting substrate (i.e. the upper electrode side), the supporting substrate need not necessarily exhibit transparency.

(2) Organic luminescent medium

The organic luminescent medium is a medium including an organic emitting layer which can emit light by electroluminescence upon recombination of electrons and holes. The organic luminescent medium may be formed by stacking each layer of one of the following (a) to (g) on the anode, for example.

     (a) Organic emitting layer
     (b) Hole injecting layer/organic emitting layer
     (c) Organic emitting layer/electron injecting layer
     (d) Hole injecting layer/organic emitting layer/electron injecting layer
     (e) Organic semiconductor layer/organic emitting layer
     (f) Organic semiconductor layer/electron barrier layer/organic emitting layer
     (g) Hole injecting layer/organic emitting layer/adhesion improving layer

The configuration (d) among the configurations (a) to (g) is particularly preferable because a higher luminance is obtained and excellent durability is achieved.
The material for the organic luminescent medium (A) and the thickness of the organic luminescent medium (B) are described below in that order.

(A) Material for organic luminescent medium

Constituent element examples of the organic luminescent medium are described below in the order of (i) organic emitting layer, (ii) hole injecting layer, (iii) electron injecting layer, and (iv) adhesion improving layer.

(i) Organic emitting layer

As examples of the luminescent material for the organic emitting layer of the organic luminescent medium, a single material or a combination of two or more of a p-quarterphenyl derivative, a p-quinquephenyl derivative, a benzodiazole compound, a benzimidazole compound, a benzoxazole compound, a metal-chelated oxynoid compound, an oxadiazole compound, a styrylbenzene compound, a distyrylpyrazine derivative, a butadiene compound, a naphthalimide compound, a perylene derivative, an aldazine derivative, a pyraziline derivative, a cyclopentadiene derivative, a pyrrolopyrrole derivative, a styrylamine derivative, a coumarin compound, an aromatic dimethylidyne compound, a metal complex having an 8-quinolinol derivative as the ligand, a polyphenyl compound, and the like can be given.

Of these organic luminescent materials, 4,4-bis(2,2-di-t-butylphenylvinyl)biphenyl (hereinafter abbreviated as DTBPBBi) and 4,4-bis(2,2-diphenylvinyl)biphenyl (hereinafter abbreviated as DPVBi) as the aromatic dimethylidyne compounds and derivatives thereof are preferable.

A material obtained by doping an organic luminescent material having a distyrylarylene skeleton or the like (host material) with a fluorescent dye which emits strong blue to red light (e.g. coumarin material) or a fluorescent dye similar to the host (dopant) may also be suitably used in combination. In more detail, it is preferable to use DPVBi or the like as the host material and N,N-diphenylaminobenzene (hereinafter abbreviated as DPAVB) or the like as the dopant.

(ii) Hole injecting layer

It is preferable to use a compound having a hole mobility measured when applying a voltage of $1 \times 10^4$ to $1 \times 10^6$ V/cm of $1 \times 10^{-6}$ cm$^2$/V·sec or more and an ionization energy of 5.5 eV or less for the hole injecting layer of the organic luminescent medium. Holes are reliably injected into the organic emitting layer by providing such a hole injecting layer, whereby a high luminance is obtained, or the device can be driven at a low voltage.

As specific examples of the material for the hole injecting layer, organic compounds such as a porphyrin compound, an aromatic tertiary amine compound, a styrylamine compound, an aromatic dimethylidyne compound, and a condensed aromatic ring compound, such as 4,4-bis[N-(1-naphthyl)-N-phenylamino]biphenyl (hereinafter abbreviated as NPD) and 4,4',4"-tris[N-(3-methylphenyl)-N-phenylamino]triphenylamine (hereinafter abbreviated as MTDATA), can be given.

It is also preferable to use an inorganic compound such as p-type Si or p-type SiC as the material for the hole injecting layer. It is also preferable to provide an organic semiconductor layer with a conductivity of $1 \times 10^{-10}$ S/cm or more between the hole injecting layer and the anode layer or between the hole injecting layer and the organic emitting layer. Holes are more reliably injected into the organic emitting layer by providing such an organic semiconductor layer.

(iii) Electron injecting layer

It is preferable to use a compound having an electron mobility measured when applying a voltage of $1 \times 10^4$ to $1 \times 10^6$ V/cm of $1 \times 10^{-6}$ cm$^2$/V·sec or more and an ionization energy of more than 5.5 eV for the electron injecting layer of the organic luminescent medium. Electrons are reliably injected into the organic emitting layer by providing such an electron injecting layer, whereby a high luminance is obtained, or the device can be driven at a low voltage.

As specific examples of the material for the electron injecting layer, a metal complex (Al chelate: Alq) of 8-hydroxyquinoline or its derivative or an oxadiazole derivative can be given.

(iv) Adhesion improving layer

The adhesion improving layer of the organic luminescent medium may be considered to be one type of electron injecting layer. Specifically, the adhesion improving layer is an electron injecting layer formed of a material exhibiting excellent adhesion to the cathode, and is preferably formed of a metal complex of 8-hydroxyquinoline, its derivative, or the like.

It is also preferable to provide an organic semiconductor layer with a conductivity of $1 \times 10^{-10}$ S/cm or more adjacent to the electron injecting layer. Electrons are more reliably injected into the organic emitting layer by providing such an organic semiconductor layer.

(B) Thickness of organic luminescent medium

The thickness of the organic luminescent medium is not particularly limited. The thickness of the organic luminescent medium is preferably 5 nm to 5 μm, for example. If the thickness of the organic luminescent medium is less than 5 nm, luminance and durability may be decreased. If the thickness of the organic luminescent medium exceeds 5 μm, a high voltage must be applied to the device. The thickness of the organic luminescent medium is more preferably 10 nm to 3 μm, and still more preferably 20 nm to 1 μm.

(3) Upper electrode

The upper electrode corresponds to the anode layer or the cathode layer depending on the configuration of the organic EL substrate. When the upper electrode corresponds to the anode layer, it is preferable to use a material with a large work function (e.g. 4.0 eV or more) for the upper electrode in order to facilitate injection of holes. When the upper electrode corresponds to the cathode layer, it is preferable to use a material with a small work function (e.g. less than 4.0 eV) for the upper electrode in order to facilitate injection of electrons. Since the display according to this embodiment is a top-emission type, the upper electrode must exhibit transparency in order to outcouple light through the upper electrode.

As the material for the cathode layer, an electrode material such as sodium, a sodium-potassium alloy, cesium, magnesium, lithium, a magnesium-silver alloy, aluminum, aluminum oxide, an aluminum-lithium alloy, indium, a rare earth metal, a mixture of the above-mentioned metal and an organic luminescent medium material, or a mixture of the above-mentioned metal and an electron injecting layer material is preferably used either individually or in combination of two or more.

In order to reduce the resistance of the upper electrode without impairing transparency, it is also preferable to stack a transparent electrode such as indium tin oxide (ITO), indium zinc oxide (IZO), copper indium (CuIn), tin oxide ($SnO_2$), or zinc oxide (ZnO) on the cathode layer, or to add a metal such as Pt, Au, Ni, Mo, W, Cr, Ta, or Al to the cathode layer either individually or in combination of two or more.

The material for the upper electrode may be at least one material selected from the group consisting of a light-transmitting metal film, a nondegenerate semiconductor, an organic conductor, a semiconductor carbon compound, and the like. For example, the organic conductor is preferably a conductive conjugated polymer, an oxidizing agent-containing polymer, a reducing agent-containing polymer, an oxidizing agent-containing low-molecular-weight material, or a reducing agent-containing low-molecular-weight material.

As examples of the oxidizing agent added to the organic conductor, Lewis acids such as iron chloride, antimony chloride, and aluminum chloride can be given. As examples of the reducing agent added to the organic conductor, an alkali metal, an alkaline earth metal, a rare earth metal, an alkali compound, an alkaline earth compound, a rare earth compound, and the like can be given. As examples of the conductive conjugated polymer, polyaniline and its derivative, polythiophene and its derivative, a Lewis acid-containing amine compound, and the like can be given.

The nondegenerate semiconductor is preferably an oxide, a nitride, or a chalcogenide compound, for example. The carbon compound is preferably amorphous carbon, graphite, or diamond-like carbon, for example.

The inorganic semiconductor is preferably ZnS, ZnSe, ZnSSe, MgS, MgSSe, CdS, CdSe, CdTe, or CdSSe, for example. The thickness of the upper electrode is preferably determined taking the sheet resistance and the like into consideration. For example, the thickness of the upper electrode is preferably 50 nm to 5000 nm, and more preferably 100 nm or more. A uniform thickness distribution and an EL emission transmittance of 60% or more are obtained by adjusting the thickness of the upper electrode within the above range. Moreover, the sheet resistance of the upper electrode can be adjusted to 15 ohm/square or less, and preferably 10 ohm/square or less.

(4) Lower electrode

The lower electrode corresponds to the cathode layer or the anode layer depending on the configuration of the organic EL display. As examples of the material for the anode layer, a single material or a combination of two or more of indium tin oxide (ITO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$), aluminum oxide ($Al_2O_3$), and the like can be given.

In the invention, since light is outcoupled from the upper electrode side, the material for the lower electrode need not necessarily exhibit transparency. If anything, it is preferable to form the lower electrode using a light-absorbing conductive material. This allows the contrast of the organic EL display to be further improved. As preferable light-absorbing conductive materials, a semiconductor carbon material, a color organic compound, a combination of the above-mentioned reducing agent and oxidizing agent, and a color conductive oxide (e.g. transition metal oxides such as $VO_X$, $MoO_X$, and $WO_X$) can be given.

The lower electrode may be formed of a reflecting material. This configuration allows light from the organic EL display to be efficiently outcoupled. As preferable reflecting materials, the metal material used for the light blocking layer and a high-refractive-index material such as titanium oxide, magnesium oxide, or magnesium sulfate can be given.

The thickness of the lower electrode is not particularly limited in the same manner as the upper electrode. For example, the thickness of the lower electrode is preferably 10 nm to 1000 nm, and more preferably 10 to 200 nm.

(5) Inter-insulator

The inter-insulator of the organic EL display is provided in the vicinity or on the periphery of the organic luminescent medium. The inter-insulator is used to increase the resolution of the entire organic EL display and prevent a short circuit between the lower electrode and the upper electrode. When driving the organic EL device using a TFT, the inter-insulator is used to protect the TFT and as an underlayer for forming the lower electrode on a flat surface.

In the invention, the inter-insulator is provided to fill the space between the lower electrodes separately provided in pixel units. Specifically, the inter-insulator is provided along the boundary between the pixels.

As examples of the material for the inter-insulator, an acrylic resin, a polycarbonate resin, a polyimide resin, a fluorinated polyimide resin, a benzoguanamine resin, a melamine resin, a cyclic polyolefin, a novolac resin, polyvinyl cinnamate, cyclized rubber, a polyvinyl chloride resin, polystyrene, a phenol resin, an alkyd resin, an epoxy resin, a polyurethane resin, a polyester resin, a maleic resin, a polyamide resin, and the like can be given.

When forming the inter-insulator using an inorganic oxide, silicon oxide ($SiO_2$ or $SiO_x$), aluminum oxide ($Al_2O_3$ or $AlO_x$), titanium oxide ($TiO_3$ or $TiO_x$), yttrium oxide ($Y_2O_3$ or $YO_x$), germanium dioxide ($GeO_2$ or $GeO_x$), zinc oxide ($ZnO$), magnesium oxide ($MgO$), calcium oxide ($CaO$), boric acid ($B_2O_3$), strontium oxide ($SrO$), barium oxide ($BaO$), lead oxide ($PbO$), zirconia ($ZrO_2$), sodium oxide ($Na_2O$), lithium oxide ($Li_2O$), potassium oxide ($K_2O$), and the like can be given as preferable inorganic oxides.

Note that x in the above inorganic compounds is in the range of $1 \leq x \leq 3$.

When heat resistance is required for the inter-insulator, it is preferable to use an acrylic resin, a polyimide resin, a fluorinated polyimide, a cyclic polyolefin, an epoxy resin, or an inorganic oxide.

When forming the inter-insulator using an organic material, the inter-insulator may be formed by introducing a photosensitive group into the material and processing the material into a desired pattern by photolithography, or forming the material into a desired pattern by printing.

The thickness of the inter-insulator is preferably 10 nm to 1 mm although the thickness varies depending on the resolution of the display and the unevenness of other members combined with the organic EL device. This is because the above configuration allows unevenness due to the TFT or the lower electrode pattern to be sufficiently reduced.

The thickness of the inter-insulator is preferably 100 nm to 100 $\mu$m, and more preferably 100 nm to 10 $\mu$m, for example.

(6) Barrier film

It is preferable to further dispose the barrier film on the organic EL substrate. Since the organic EL device tends to deteriorate due to water and oxygen, the barrier film is used to block water and oxygen.

As specific examples of the material for the barrier film, transparent inorganic substances such as $SiO_2$, $SiO_x$, $SiO_xN_y$, $Si_3N_4$, $Al_2O_3$, $AlO_xN_y$, $TiO_2$, $TiO_x$, $SiAlO_xN_y$, $TiAlO_x$, $TiAlo_xN_y$, $SiTiO_x$, and $SiTiO_xN_y$ are preferable.

When using such a transparent inorganic substance, it is preferable to form the barrier film at a low temperature (100°C or less) and a low film forming rate so that the organic EL device does not deteriorate. It is preferable to use a method such as sputtering, deposition, or CVD.

It is preferable that the transparent inorganic substance be amorphous, since such a transparent inorganic substance exhibits an excellent effect of blocking water, oxygen, a low-molecular-weight monomer, and the like to reduce deterioration of the organic EL device.

The thickness of the barrier film is preferably 10 nm to 1 mm.

If the thickness of the barrier film is less than 10 nm, a large amount of water or oxygen may permeate the barrier film.

If the thickness of the barrier film exceeds 1 mm, the thickness of the display may not be reduced due to the increased thickness of the barrier film.

The thickness of the barrier film is more preferably 10 nm to 100 $\mu$m.

3. Sealing medium

The sealing medium is provided between the organic EL substrate and the color conversion substrate. The sealing medium blocks water and monomers produced from the color conversion substrate and adjusts the refractive index for efficiently introducing light from the organic EL device into the color conversion layer.

As the material for the sealing medium, a transparent resin and a sealing liquid can be given.

As the transparent resin which may be used as the material for the sealing medium, polyphenyl methacrylate, polyethylene terephthalate, poly-o-chlorostyrene, poly-o-naphthyl methacrylate, polyvinylnaphthalene, polyvinylcarbazole, fluorene skeleton-containing polyester, and the like can be given. A sealing adhesive described later may also be used insofar as the sealing adhesive is transparent.

As the sealing liquid which may be used as the material for the sealing medium, a fluorinated hydrocarbon, a fluorinated olefin oligomer, and the like can be given.

Note that the refractive index of the sealing medium may be adjusted by adding an aromatic ring-containing compound, a fluorene skeleton-containing compound, a bromine-containing compound, a sulfur-containing compound, a high-refractive-index compound e.g., a metal compound such as alkoxytitanium (dimethoxytitanium or diethoxytitanium), alkoxytitanium, or the like.

It is preferable to adjust the refractive index of the sealing medium to a value smaller than the refractive index of the barrier film or the upper electrode and greater than the refractive index of the color conversion layer (particularly the fluorescent layer), since interfacial reflection between the layers and the films can be reduced.

4. Sealing adhesive layer

The sealing adhesive layer is a layer which bonds the organic EL substrate and the color conversion substrate on the periphery of the display portion of the organic EL display.

In more detail, it is preferable to form the sealing adhesive layer using a UV-curable resin, a visible light-curable resin, a heat-curable resin, or an adhesive using these resins. Specific examples of these materials include commercially available products such as Luxtrak LCR0278, 0242D (manufactured by Toagosei Co., Ltd.), TB3113 (epoxy adhesive, manufactured by Three Bond Co., Ltd.), and Benefix VL (acrylic adhesive, manufactured by Adell Corporation).

EXAMPLES

Example 1

(1) Formation of TFT substrate

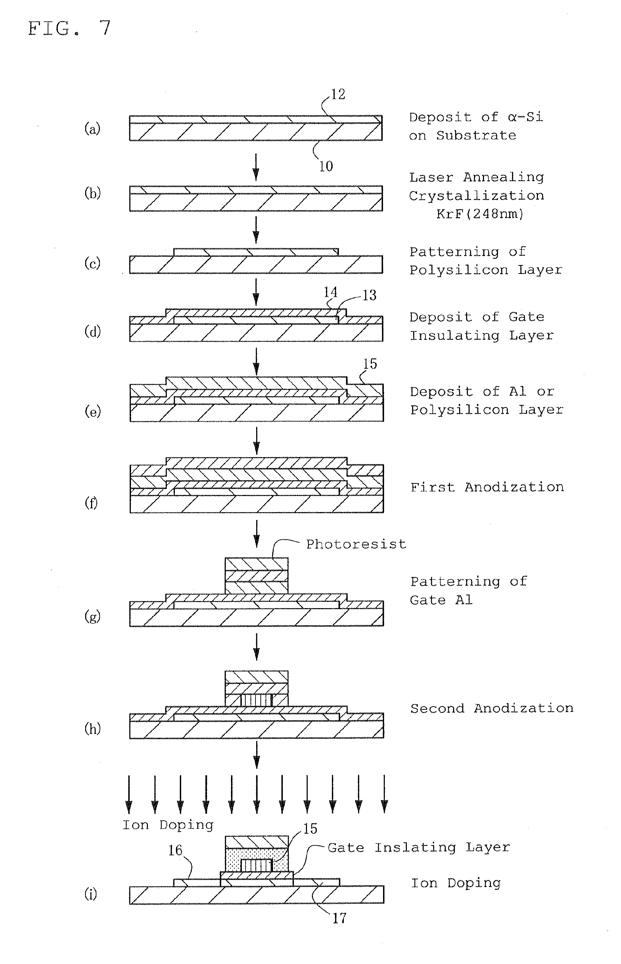

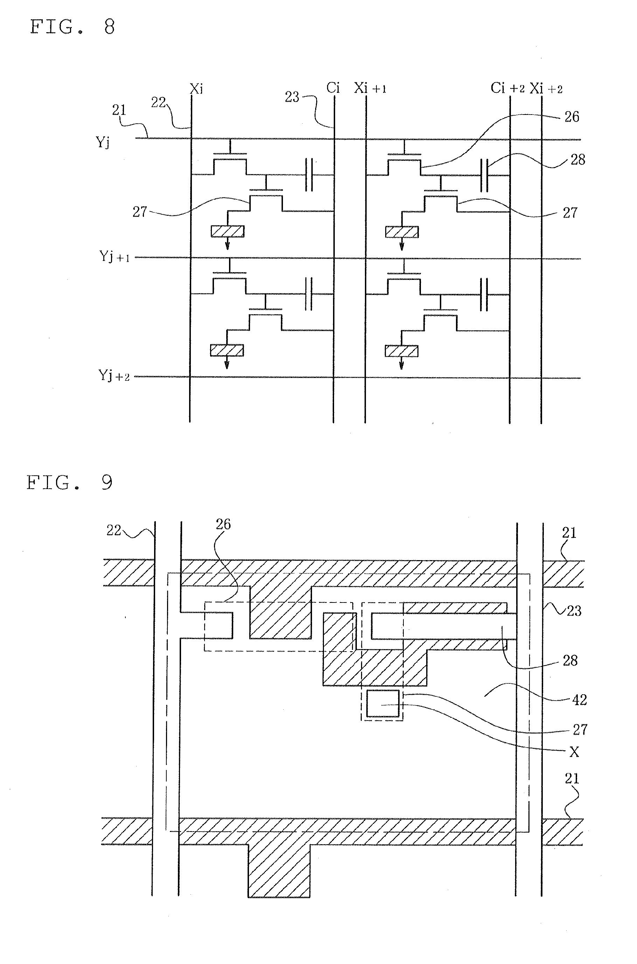

FIGS. 7(a) to 7(i) are views showing polysilicon TFT formation steps. FIG. 8 is a circuit diagram showing an electric switch connection structure including a polysilicon TFT, and FIG. 9 is a planar perspective view showing an electric switch connection structure including a polysilicon TFT.

An $\alpha$-Si layer 12 was stacked on a glass substrate 10 (OA2 glass manufactured by Nippon Electric Glass Co., Ltd.) with dimensions of 112 mm $\times$ 143 mm $\times$ 1.1 mm using a method such as low pressure chemical vapor deposition (LPCVD) (FIG. 7(a)). The $\alpha$-Si layer 12 was subjected to annealing crystallization by applying laser light to the $\alpha$-Si layer 12 from an excimer laser such as a KrF (248 nm) laser to form polysilicon (FIG. 7(b)). The polysilicon was patterned by photolithography in the shape of islands (FIG. 7(c)). An insulating gate material 14 was stacked on the surfaces of the island-shaped polysilicon 13 and the substrate 10 by chemical vapor deposition (CVD) or the like to form a gate oxide insulating layer 14 (FIG. 7(d)). After forming a gate electrode 15 by deposition or sputtering (FIG. 7(e)), the gate electrode 15 was patterned and anodic oxidation was performed (FIGS. 7(f) to 7(h)). Then, doped regions (active layer) were formed by ion doping (ion implantation) to form a source 16 and a drain 17 to obtain a polysilicon TFT (FIG. 7(i)). The gate electrode 15 (and scan electrode 21 and bottom electrode of capacitor 28 shown in FIG. 8) was formed of Al, and the source 16 and the drain 17 of the TFT were n+-type.

After forming an inter-insulator ($SiO_2$) on the resulting active layer by CRCVD to a thickness of 500 nm, a signal electrode 22, a common electrode 23, and a capacitor upper electrode (Al) were formed. A source electrode of a second transistor (Tr2) 27 was connected with the common electrode, and a drain of a first transistor (Tr1) 26 was connected with the signal electrode (FIGS. 8 and 9). The TFT and the electrode were connected after appropriately removing the inter-insulator $SiO_2$ by wet etching using hydrofluoric acid.

An Al film and an IZO (indium zinc oxide) film were formed by sputtering to a thickness of 2000 angstroms and 1300 angstroms, respectively. A positive resist ("HPR204" manufactured by FUJIFILM Arch Co., Ltd.) was applied to the substrate by spin coating, and ultraviolet rays were applied through a photomask patterned so that a 100 $\mu$m $\times$ 320 $\mu$m dot-shaped pattern was formed. The resist was developed using a tetramethylammonium hydroxide (TMAH) developer and baked at 130°C to obtain a resist pattern.

The exposed IZO was etched using an IZO etchant containing 5% oxalic acid, and the Al was etched using a phosphoric acid/acetic acid/nitric acid aqueous solution. The resist was treated with a stripper containing ethanolamine as the main component ("106" manufactured by Tokyo Ohka Kogyo Co., Ltd.) to obtain an Al/IZO pattern (lower electrode: anode). In this step, the Tr2 27 and the lower electrode 42 were connected through an opening X (FIG. 9).

As a second inter-insulator, a black negative resist ("V259BK" manufactured by Nippon Steel Chemical Co., Ltd.) was applied by spin coating, irradiated with ultraviolet rays, and developed using a tetramethylammonium hydroxide (TMAH) developer. The resulting resist was baked at 220°C to form an inter-insulator of an organic film covering the edge of the Al/IZO (thickness: 1 $\mu$m, IZO opening: 90 $\mu$m $\times$ 310 $\mu$m) (not shown).

(2) Fabrication of organic EL device

The resulting substrate provided with the inter-insulator was subjected to ultrasonic cleaning in pure water and isopropyl alcohol, dried by air blowing, and subjected to UV cleaning.

The TFT substrate was transferred to an organic deposition device (manufactured by ULVAC, Inc.) and secured on a substrate holder. Molybdenum heating boats were respectively charged in advance with 4,4',4"-tris[N-(3-methylphenyl)-N-phenylamino]triphenylamine (MTDATA) and 4,4'-bis[N-(1-naphthyl)-N-phenylamino]biphenyl (NPD) as a hole injecting material, 4,4'-bis(2,2-diphenylvinyl)biphenyl (DPVBi) as a host of an emitting material, 1,4-bis[4-(N,N-diphenylaminostyrylbenzene)] (DPAVB) as a dopant, and tris(8-quinolinol)aluminum (Alq) and Li as an electron injecting material and a cathode. An IZO (indium zinc oxide) target was provided in another sputtering container as a cathode extraction electrode.

After reducing the pressure inside the vacuum container to $5 \times 10^{-7}$ torr, layers were stacked as described below in the order from the hole injecting layer to the cathode without breaking the vacuum.
As the hole injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi and DPAVB were co-deposited to a thickness of 50 nm at a deposition rate of 0.1 to 0.3 nm/sec and 0.03 to 0.05 nm/sec, respectively. As the electron injecting layer, Alq was deposited to a thickness of 20 nm at a deposition rate of 0.1 to 0.3 nm/sec. As the cathode, Alq and Li were co-deposited to a thickness of 20 nm at a deposition rate of 0.1 to 0. 3 nm/sec and 0.005 nm/sec, respectively.
After transferring the substrate to the sputtering container, an IZO film was formed in a thickness of 200 nm at a film forming rate of 0.1 to 0. 3 nm/sec as the cathode extraction electrode to fabricate an organic EL device.

(3) Formation of barrier film and completion of organic EL substrate

As a barrier film, $SiO_xN_y$ (O/O+N=50%: atomic ratio) was deposited as a transparent inorganic film on the IZO electrode of the organic EL device by low-temperature CVD to a thickness of 200 nm. An organic EL substrate was thus obtained.

(4) Formation of color conversion substrate (transparent substrate and color conversion layer)

V259G (manufactured by Nippon Steel Chemical Co., Ltd.) as the material for a green color filter was applied by spin coating to a supporting substrate (transparent substrate) (OA2 glass manufactured by Nippon Electric Glass Co., Ltd.) with dimensions of 102 mm $\times$ 133 mm $\times$ 1.1 mm. Ultraviolet rays were applied to the material through a photomask patterned so that 320 rectangular stripe patterns (100-$\mu$m line and 230-$\mu$m gap) were obtained. The material was developed using a 2% sodium carbonate aqueous solution and baked at 200°C to obtain a green color filter pattern (thickness: 1.5 $\mu$m).
V259R (manufactured by Nippon Steel Chemical Co., Ltd.) as the material for a red color filter was applied by spin coating. Ultraviolet rays were applied to the material through a photomask patterned so that 320 rectangular stripe patterns (100-$\mu$m line and 230-$\mu$m gap) were obtained. The material was then developed using a 2% sodium carbonate aqueous solution and baked at 200°C to obtain a red color filter pattern (thickness: 1.5 $\mu$m) adjacent to the green color filter.
VPA204/P5.4-2 (manufactured by Nippon Steel Chemical Co., Ltd.) as the material for a transparent partition wall was applied by spin coating. Ultraviolet rays were applied to the material through a photomask patterned so that a grid-like pattern was formed. The material was developed using a 2% sodium carbonate aqueous solution and baked at 200°C to obtain a transparent partition wall pattern (thickness: 25 $\mu$m). The transparent partition wall had a transmittance of light in the visible region at a wavelength of 400 nm to 700 nm of more than 10% (transmittance at 450 nm was 95%) . The line width of the grid-like pattern was 20 $\mu$m. The opening had a size of 90 $\mu$m $\times$ 310 $\mu$m (aperture ratio was 77%) . Therefore, the aspect ratio of the transparent partition wall was height (thickness)/width=25/20=1.25.
As the material for a blue color filter, an ink was prepared by dispersing a 3% (in solid content) of a copper phthalocyanine pigment (Pigment Blue 15: 6) in an epoxy-based thermosetting ink ("1300" manufactured by Seiko Advance Ltd.).
The ink was poured by screen printing into the opening between the partition walls in which the color filter was not formed, and treated at 150°C for 30 minutes to form a blue color filter pattern (thickness: 20 $\mu$m).
As a green fluorescent material, an ink was prepared by dissolving coumarin 6 in an epoxy-based thermosetting ink ("1300" manufactured by Seiko Advance Ltd.) in an amount of 0. 02 mol/kg (in solid content).
The ink was poured by screen printing into the opening between the partition walls over the green color filter, and treated at 150°C for 30 minutes to form a green fluorescent material pattern (thickness: 20 $\mu$m).
As a red fluorescent material, an ink was prepared by dissolving 0.53 g of coumarin 6, 0.15 g of basic violet 11, and 0.15 g of rhodamine 6G in 90 g of an epoxy-based thermosetting ink ("1300" manufactured by Seiko Advance Ltd., solid content: 55%).
The ink was poured by screen printing into the opening between the partition walls over the red color filter, and treated at 150°C for 30 minutes to form a red fluorescent material pattern (thickness: 20 $\mu$m) to obtain a color conversion substrate.

(5) Bonding upper and lower substrates

A photocurable adhesive ("TB3113" manufactured by Three Bond Co., Ltd.) was applied to the periphery of the display region on the organic EL substrate using a dispenser. The color conversion substrate was positioned on the organic EL substrate so that the color conversion layer (fluorescent layer and/or color filter) of the color conversion substrate receives light from the organic EL device (so that the transparent partition wall was positioned to overlap the second inter-insulator of the organic EL substrate). The organic EL substrate and the color conversion substrate were bonded by applying ultraviolet rays to the photocurable adhesive to obtain an organic EL display (aperture ratio: 77%). The space between the partition walls of the color conversion substrate was filled with a liquid fluorinated hydrocarbon ("Demnum" manufactured by Daikin Industries, Ltd.) as a sealing medium (refractive index adjusting material).

(6) Characteristic evaluation of organic EL display

An active organic EL display was produced as described above. When applying a DC voltage of 7 V between the lower electrode (IZO/Al) and the upper electrode (IZO) (lower electrode: (+), upper electrode: (-)), light was emitted from the intersection (pixel) of the electrodes.
The luminance was measured using a chromameter ("CS100" manufactured by Minolta). The luminance at the blue color filter (blue pixel) was 24 cd/m$^2$, and the CIE chromaticity coordinates were X=0.12 and Y=0.18 (blue light). The luminance at the green fluorescent layer/green color filter (green pixel) was 72 cd/m$^2$, and the CIE chromaticity coordinates were X=0.27 and Y=0.67 (green light). The luminance at the red fluorescent layer/red color filter (red pixel) was 30 cd/m$^2$, and the CIE chromaticity coordinates were X=0.64 and Y=0.35 (red light). Specifically, light of the three primary colors was obtained. Therefore, the white luminance was 126 cd/m$^2$.
The luminance of the organic EL substrate was 300 cd/m$^2$ (corresponding to the operation of all pixels, the luminance of the pixel of each color was 1/3 the luminance of the organic EL substrate). The CIE chromaticity coordinates were X=0.17 and Y=0.28 (blue light).
The contrast ratio (luminance when the EL display operated: luminance when the EL display did not operate) when illuminated to 1000 lux using a fluorescent lamp was 84:1.
The organic EL display was subjected to a heat cycle test (-40°C to 85°C, 100 cycles) and observed with the naked eye before and after the test. An operation test was also performed. No abnormalities were observed.

Example 2

An organic EL display was obtained in the same manner as in Example 1 except for forming a thin light blocking layer with a thickness of 1.0 $\mu$m ("V259BK" manufactured by Nippon Steel Chemical Co., Ltd.) at the bottom of the transparent partition wall before forming the color filter under the same conditions as the formation conditions for the green or red color filter.
The characteristics of the resulting organic EL display were evaluated. The same results were obtained for the luminance and the heat cycle test. On the other hand, the contrast ratio was improved to 105:1. This is considered to be because excitation of the fluorescent layer due to external light and reflection from the organic EL substrate were reduced by forming the thin light blocking layer at the bottom of the transparent partition wall.

Example 3

An organic EL display was obtained in the same manner as in Example 1 except for dispersing 10% (in solid content) of titania particles ("MT500HD" manufactured by TAYCA Corporation) in VPA204/P5.4-2 (manufactured by Nippon Steel Chemical Co., Ltd.) as the material for the transparent partition wall.
The refractive index of the resulting transparent partition wall was 2.0, which is greater than the refractive indices of the color filter and the fluorescent layer (1.5 to 1.6) in an amount of 0.4 or more.
The characteristics of the resulting organic EL display were evaluated. The CIE chromaticity coordinates at the blue color filter (blue pixel) were X=0.12 and Y=0.16 (blue light). The CIE chromaticity coordinates at the green fluorescent layer/green color filter (green pixel) were X=0.25 and Y=0.68 (green light). The CIE chromaticity coordinates at the red fluorescent layer/red color filter (red pixel) were X=0.65 and Y=0.35 (red light). Specifically, color reproducibility (chromatic purity) was improved in comparison with Example 1.
This is considered to be because mixing of light between the color conversion layers was reduced by allowing the refractive index of the partition wall to differ from the refractive indices of the color filter and the fluorescent layer.

Example 4

An organic EL display was obtained in the same manner as in Example 1 except for forming a positive resist ("HPR204" manufactured by FUJIFILM Arch Co., Ltd.) pattern (thickness: 1.5 $\mu$m) between the partition walls by photolithography after forming the transparent partition walls, depositing Al over the entire surface of the substrate as a reflecting layer, and removing the positive resist pattern and the Al film between the partition walls using an organic alkali ("N303" manufactured by Nagase & Co., Ltd.) to form an Al film (thickness: 1500 angstroms) on the side of the partition wall.

The characteristics of the resulting organic EL display were evaluated. The luminance was measured using a chromameter ("CS100" manufactured by Minolta). The luminance at the blue color filter (blue pixel) was 27 cd/m$^2$, and the CIE chromaticity coordinates were X=0.12 and Y=0.16 (blue light) . The luminance at the green fluorescent layer/green color filter (green pixel) was 80 cd/m$^2$, and the CIE chromaticity coordinates were X=0.25 and Y=0.68 (green light). The luminance at the red fluorescent layer/red color filter (red pixel) was 33 cd/m$^2$, and the CIE chromaticity coordinates were X=0.65 and Y=0.35 (red light). Specifically, light of the three primary colors was obtained. Therefore, the white luminance was 140 cd/m$^2$. The luminance and color reproducibility (chromatic purity) were improved in comparison with Example 1.

This is considered to be because light from the color conversion layer was effectively utilized for display by the reflecting layer and mixing of light between the color conversion layers was reduced by disposing Al at least on the side of the partition wall.

Example 5

An organic EL display was obtained in the same manner as in Example 1 except for forming the transparent partition wall with a reverse-tapered (reverse-trapezoidal) cross-sectional shape. Specifically, after spin coating the transparent partition wall material (VPA204/P5.4-2), ultraviolet rays were applied to the material at a dose 1/3 the dose of Example 1. As a result, the grid-like pattern was provided with a reverse-tapered (reverse-trapezoidal) shape. The width of the grid-like pattern at the top (organic EL side) was 20 $\mu$m, and the width of the grid-like pattern at the bottom (color conversion substrate side) was 12 $\mu$m. The thickness of the partition wall was 25 $\mu$m.

The surface of the color conversion layer pattern including the blue color filter, the green fluorescent material/green color filter, and the red fluorescent material/red color filter was planarized in comparison with Example 1 by using such a transparent partition wall. The variation in chromaticity between the emitted colors was 0.02 or less.

Example 6

A semiconductor nanocrystal (CdSe) ZnS was used in Example 1 as the red fluorescent material. Specifically, cadmium acetate dihydrate (0.5 g) and tetradecylphosphonic acid (TDPA) (1.6 g) were added to 5 ml of trioctyl phosphine (TOP). The solution was heated to 230°C in a nitrogen atmosphere and stirred for one hour. After cooling the solution to 60°C, 2 ml of a TOP solution containing 0.2 g of selenium was added to the solution to obtain a raw material solution. Trioctyl phosphine oxide (TOPO) (10 g) was placed in a three-necked flask and dried at 195°C for one hour under vacuum. After adjusting the pressure inside the flask to atmospheric pressure using nitrogen gas, the TOPO was heated to 270°C in a nitrogen atmosphere. 1.5 ml of the above raw material solution was then added to the TOPO at a time while stirring the system. The reaction (core growth reaction) was allowed to proceed while appropriately checking the fluorescence spectrum of the reaction solution. When the nanocrystal exhibited a fluorescence peak at 615 nm, the reaction solution was cooled to 60°C to terminate the reaction.

20 ml of butanol was added to the reaction solution to precipitate the semiconductor nanocrystal (core). The semiconductor nanocrystal was separated by centrifugation and dried under reduced pressure.

TOPO (5 g) was placed in a three-necked flask and dried at 195°C for one hour under vacuum. After adjusting the pressure inside the flask to atmospheric pressure using nitrogen gas, the TOPO was cooled to 60°C in a nitrogen atmosphere. Then, TOP (0.5 ml) and the semiconductor nanocrystal (core) (0.05 g) suspended in 0.5 ml of hexane were added to the TOPO. After stirring the mixture at 100°C for one hour under reduced pressure, the mixture was heated to 160°C. The pressure inside the flask was then adjusted to atmospheric pressure using nitrogen gas (solution A).

A solution B (prepared by dissolving 0.7 ml of a 1N n-hexane solution of diethyl zinc and 0.13 g of bis(trimethylsilyl) sulfide in 3 ml of TOP) was added dropwise to the solution A maintained at 160°C over 30 minutes. The mixture was cooled to 90°C and stirred for two hours. After cooling the mixture to 60°C, 20 ml of butanol was added to the reaction solution to precipitate the semiconductor nanocrystal (core: CdSe, shell: ZnS). The semiconductor nanocrystal was separated by centrifugation and dried under reduced pressure.

The resulting semiconductor nanocrystal was dispersed in an epoxy-based thermosetting ink ("1300" manufactured by Seiko Advance Ltd.) as a binder resin so that the concentration (in solid content) of the semiconductor nanocrystal was 28 wt% (volume ratio: 7 vol%) to prepare a red fluorescent material using the semiconductor nanocrystal (CdSe)ZnS. A red fluorescent material pattern (thickness: 20 $\mu$m) was formed in the same manner as in Example 1 to obtain a color conversion substrate, and an organic EL display was obtained in the same manner as in Example 1.

The characteristics of the organic EL display were evaluated. The luminance and the CTE chromaticity coordinates at the red fluorescent material/red color filter (red pixel) were respectively 45 cd/m$^2$ and X=0 . 65 and Y=0.34. Specifically, the red luminous efficiency and chromaticity were improved.

The CIE chromaticity coordinates at the green fluorescent material/green color filter (green pixel) were improved to X=0.25 and Y=0.68. The color reproducibility of the organic EL display was improved.

The chromaticity of the green pixel was considered to be improved for the following reason. Specifically, since the semiconductor nanocrystal particles were used, the average refractive index of the red fluorescent layer was increased. Accordingly, the difference in refractive index between the red fluorescent layer and the transparent partition wall was increased, whereby mixing of light from the red conversion layer into the adjacent green conversion layer was reduced.

Comparative Example 1 (thick light blocking layer)

A thick (25 $\mu$m) light blocking layer ("V259BK" manufactured by Nippon Steel Chemical Co., Ltd.) was formed in Example 1 instead of the transparent partition wall. However, a pattern could not be formed since ultraviolet rays were not sufficiently transmitted when the line width was 20 $\mu$m.

A light blocking layer could be obtained by setting the line width at 55 $\mu$m. The opening had a size of 55 $\mu$m $\times$ 275 $\mu$m (aperture ratio was 42%). Therefore, the aspect ratio of the resulting thick light blocking layer was height (thickness)/width=25/55=0.45.

An organic EL display was obtained in the same manner as in Example 1 using the resulting color conversion substrate. The characteristics of the resulting organic EL display were evaluated in the same manner as in Example 1. The luminance was measured using a chromameter ("CS100" manufactured by Minolta). The luminance at the blue color filter (blue pixel) was 13 cd/m$^2$, and the CIE chromaticity coordinates were X=0.12 and Y=0.16 (blue light) . The luminance at the green fluorescent layer/green color filter (green pixel) was 39 cd/m$^2$, and the CIE chromaticity coordinates were X=0.25 and Y=0.68 (green light). The luminance at the red fluorescent layer/red color filter (red pixel) was 16 cd/m$^2$, and the CIE chromaticity coordinates were X=0.65 and Y=0.35 (red light). Specifically, light of the three primary colors was obtained. Therefore, the white luminance was 68 cd/m$^2$. The luminance was significantly decreased in comparison with Example 1.

The reason therefor is as follows. Specifically, since the light blocking layer could not be patterned with a high resolution, the aperture ratio of the color conversion substrate was significantly decreased, whereby the luminance (luminous efficiency) of a high-resolution organic EL display could not be sufficiently obtained.

Comparative Example 2 (without spacer function)

In Example 1, a color conversion substrate was obtained in which the transparent partition wall was polished to a thickness approximately the same as the thickness of the color conversion layer (thickness: 20 $\mu$m). A photocurable adhesive ("TB3113" manufactured by Three Bond Co., Ltd.) was applied to the entire surface of the color conversion substrate. The color conversion substrate was positioned on the organic EL substrate so that the color conversion layer (fluorescent layer and/or color filter) of the color conversion substrate receives light from the organic EL device (so that the transparent partition wall was positioned to overlap the second inter-insulator of the organic EL substrate). The organic EL substrate and the color conversion substrate were bonded by applying ultraviolet rays to the photocurable adhesive to obtain an organic EL display.

The resulting organic EL display was subjected to a heat cycle test (-40°C to 85°C, 100 cycles) and observed with the naked eye before and after the test. An operation test was also performed. Light was not emitted from a number of pixels since the organic layer of the organic EL substrate was separated due to stress.

INDUSTRIAL APPLICABILITY

The organic EL display according to the invention is used for consumer and industrial displays such as displays for portable display terminals, car-mounted displays such as displays for car navigation systems and instrumental panels, personal computers for office automation (OA), TVs, and displays for factory automation (FA). In particular, the organic EL display is used for thin and flat monochrome, multicolor, or full-color displays and the like.

**Claims**

1. An organic EL display comprising:

   an organic EL substrate wherein organic EL devices are formed on a first substrate,
   a color conversion substrate wherein color conversion layers are formed on a second substrate, the organic EL substrate and the color conversion substrate being arranged in such a way that the organic EL devices face the color conversion layers,
   transparent walls which are thicker than the color conversion layers and are provided between the color conversion layers of the color conversion substrate, the transparent walls being partition walls for separating the color conversion layers and being spacers between the organic EL substrate and the color conversion substrate, and
   a sealing medium, the sealing medium and the color conversion layers being provided between the transparent walls.

2. The organic EL display according to claim 1, wherein a light blocking layer is formed at the upper and/or under parts of the transparent walls.

3. The organic EL display according to claim 1, wherein a refractive index of the transparent walls is different from a refractive index of the color conversion layers.

4. The organic EL display according to claim 1, wherein a side of the transparent walls has a function of reflecting visible light.

5. The organic EL display according to claim 4, wherein a visible light reflecting layer is formed on the side of the transparent walls.

6. The organic EL display according to claim 1, wherein a width of the transparent walls becomes smaller gradually or stepwise from the first substrate toward the second substrate.

7. The organic EL display according to claim 1, wherein the color conversion layers comprise semiconductor particles.

8. The organic EL display according to claim 1, wherein the color conversion layers comprise a fluorescent layer and/or a color filter.

9. The organic EL display according to claim 1, wherein the organic EL devices are active-driven.

FIG.1

FIG.2

(a)

(b)

(c)

FIG.3

FIG.4

FIG.5

60

80    80    80    80

(a)

60

81

80    80    80    80

(b)

FIG.6

70    80

60

(a)

Width

70    80'

60

(b)

FIG. 7

(a)     Deposit of α-Si on Substrate

(b)     Laser Annealing Crystallization KrF(248nm)

(c)     Patterning of Polysilicon Layer

(d)     Deposit of Gate Insulating Layer

(e)     Deposit of Al or Polysilicon Layer

(f)     First Anodization

(g)     Photoresist     Patterning of Gate Al

(h)     Second Anodization

(i)     Ion Doping     Gate Inslating Layer     Ion Doping

FIG. 8

FIG. 9

<p style="text-align:center;">**INTERNATIONAL SEARCH REPORT**</p>

| International application No. |
| --- |
| PCT/JP2005/014127 |

| A. CLASSIFICATION OF SUBJECT MATTER |
| --- |
| Int.Cl⁷ H05B33/04, 33/12, 33/14 |

According to International Patent Classification (IPC) or to both national classification and IPC

| B. FIELDS SEARCHED |
| --- |
| Minimum documentation searched (classification system followed by classification symbols) |
| Int.Cl⁷ H05B33/04, 33/12, 33/14 |

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | JP 2003-229260 A (Dainippon Printing Co., Ltd.), 15 August, 2003 (15.08.03), Par. Nos. [0029] to [0096]; Figs. 1, 4 (Family: none) | 1-9 |
| A | JP 2004-39580 A (Dainippon Printing Co., Ltd.), 05 February, 2004 (05.02.04), Par. Nos. [0008] to [0052]; Fig. 3 (Family: none) | 1-9 |
| A | JP 2003-243154 A (Fuji Electric Co., Ltd.), 29 August, 2003 (29.08.03), Par. Nos. [0061] to [0072]; Fig. 1 (Family: none) | 1-9 |

| ☒ Further documents are listed in the continuation of Box C. | ☐ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 31 August, 2005 (31.08.05) | 13 September, 2005 (13.09.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

<p style="text-align:center;">27</p>

EP 1 784 054 A1

**INTERNATIONAL SEARCH REPORT**

International application No.

PCT/JP2005/014127

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-282259 A  (Fuji Electric Co., Ltd.),<br>03 October, 2003 (03.10.03),<br>Par. Nos. [0008] to [0048]; Fig. 1<br>& WO 2004/112438 A1 | 1-9 |

Form PCT/ISA/210 (continuation of second sheet) (January 2004)

28

**REFERENCES CITED IN THE DESCRIPTION**

**Patent documents cited in the description**

- WO 9834437 A
- JP 2004103534 A
- JP 2003243154 A
- JP 2003282259 A
- JP 2003257658 A
- JP 2003229260 A
- JP 2002510866 T